# EUROPEAN PATENT APPLICATION

(11) **EP 4 442 869 A1**
(43) Date of publication of application: **09.10.2024**
(21) Application number: 22900479.1
(22) Date of filing: 29.11.2022
(51) Int. Cl.: C30B 33/02, C30B 29/06

(54) **METHOD FOR ELIMINATING GAP-TYPE DEFECT B-SWIRL, AND SILICON WAFER AND ELECTRONIC DEVICE**

(30) Priority: 30.11.2021 CN 202111450289
(71) Applicant: Zhonghuan Advanced Semiconductor Technology Co., Ltd., Wuxi, Jiangsu 214203 (CN)
(72) Inventor: WANG, Zhen, Xuzhou, Jiangsu 221004 (CN); LI, Qinghai, Xuzhou, Jiangsu 221004 (CN); XU, Wujing, Xuzhou, Jiangsu 221004 (CN); WU, Wei, Xuzhou, Jiangsu 221004 (CN)
(74) Representative: Grassi, Stefano
(86) International application number: PCT/CN2022/135093
(87) International publication number: WO 2023/098675

(57) **Abstract**

A method for eliminating an interstitial-type defect B-swirl, a silicon wafer, and an electronic device are provided. The method includes: (1) in an inert atmosphere, raising a temperature of a monocrystalline silicon wafer having an interstitial-type defect B-swirl to a first preset temperature, and holding at the first preset temperature; (2) in a nitrogen atmosphere, raising a temperature of the silicon wafer, which is obtained in step (1) to a second preset temperature, and holding at the second preset temperature; (3) reducing the temperature of the silicon wafer obtained in step (2) to a third preset temperature, and removing the nitrogen atmosphere; and (4) in the inert atmosphere, raising the temperature of the silicon wafer obtained in step (3) to a fourth preset temperature, and holding at the forth temperature.

## Description

### Cross-Reference to Related Application

This application claims priority and interests to Patent Application No. 202111450289.3, filed with the China National Intellectual Property Administration on November 30, 2021, the disclosure of which is incorporated herein by reference in its entirety.

### Technical Field

The present disclosure belongs to the technical field of semiconductors, and in particular, to a method for eliminating an interstitial-type defect B-swirl in a silicon wafer, a silicon wafer, and an electronic device.

### Background

The semiconductor industry is developed towards two aspects: on the one hand, a size of a characteristic line width is continuously reduced. On the other hand, a size of silicon wafer continues to increase. In recent years, with the rapid development of the integrated circuit industry, the technological upgrading of the integrated circuit industry is further promoted. With the further reduction of the size of the line width, the higher requirements are put forward for the quality of monocrystalline silicon wafers. In actual production, monocrystalline silicon is generally produced by Czochralski (CZ) method. The increase in the size of silicon wafer can cause the pulling speed of monocrystalline silicon to slow down during the crystal growth process and prolong the crystal growth time, ultimately the size of an original defect in the monocrystalline silicon becomes larger. When the size of the original defect in the monocrystalline silicon reaches 1/3 of the characteristic line width of a device, it will directly lead to the performance failure of the device. Therefore, people begin to pay attention to the size of defects in silicon. According to Voronkov's theory, during the Czochralski silicon crystal growth process, the ratio of a crystal growth rate (V) to a temperature gradient (G) at the solid-liquid interface is strictly controlled to a specific value, a perfect crystal without defects can be obtained. However, it is difficult to stabilize the V/G value in practical operations, and the crystal growth rate V is too slow, which often cause an interstitial-type defect, especially at the slow speed of the ingot head, and the ingot often has an interstitial-type defect, forming a silicon wafer with the interstitial-type defect B-swirl, leading to a leakage problem in an integrated circuit (IC) manufacturing process, and such silicon wafers have to be scrapped.

How to eliminate interstitial-type defects in the monocrystalline silicon wafer is an urgent technical problem that needs to be solved at present.

### Summary

The present disclosure aims to at least solve one of the technical problems in the related art to a certain extent. Therefore, the present disclosure aims to provide a method for eliminating an interstitial-type defect B-swirl, a monocrystalline silicon wafer, and an electronic device. The present disclosure eliminates the interstitial-type defect B-swirl in the monocrystalline silicon wafer through high temperature rapid thermal process without generating new defects, and improves the quality of the silicon wafer.

According to one aspect of the present disclosure, the present disclosure provides a method for eliminating an interstitial-type defect B-swirl in a silicon wafer. According to an embodiment of the present disclosure, the method includes:
(1) In an inert atmosphere, a temperature of a monocrystalline silicon wafer, which has an interstitial-type defect B-swirl, is raised to a first preset temperature, and the temperature is maintained, so as to eliminate a thermal donor inside the silicon wafer;
(2) In a nitrogen atmosphere, a temperature of the silicon wafer, which is obtained in step (1) is raised to a second preset temperature, and the temperature is maintained, so as to form a vacancy region on a near surface of silicon wafer;
(3)The temperature of the silicon wafer, which is obtained in step (2), is reduced to a third preset temperature, and the nitrogen atmosphere is removed, so as to remain vacancies of the vacancy region on the near surface of silicon wafer; and
(4) In the inert atmosphere, the temperature of the silicon wafer, which is obtained in step (3) is raised to a fourth preset temperature, and the temperature is maintained, so as to enable self-interstitial silicon atoms in the silicon wafer to diffuse outside and recombine with the vacancies on the near surface for annihilation.

According to the method for eliminating the interstitial-type defect B-swirl in the silicon wafer according to the embodiment of the present disclosure, the silicon wafer with the interstitial-type defect B-swirl is first raised to the first preset temperature, and the temperature is maintained, so as to eliminate the thermal donor inside the silicon wafer, that is to eliminate interstitial oxygen located at an interstitial position in the silicon wafer; then raised the temperature to the second preset temperature in nitrogen atmosphere, and the temperature is maintained so as to form a vacancy region on the near surface of silicon wafer; then reduced to the third preset temperature, and the nitrogen atmosphere is removed, so as to remain the vacancies of the vacancy region on the near surface of silicon wafer and prevent the vacancies from diffusing outwards during the continuous high temperature process, resulting in a decrease in the concentration of vacancies of the near surface; finally, the temperature of the silicon wafer is raised to the fourth preset temperature, and the temperature is maintained, so as to make the self-interstitial silicon atoms in the silicon wafer diffuse outwards, recombining and annihilating with the vacancies on the near surface. Thus, the interstitial-type defect B-swirl in the silicon wafer is eliminated through high-temperature rapid thermal process, so that the silicon wafer is turned into a perfect wafer without new defects, which improves the quality of the silicon wafer without affecting the effect of an IC manufacturing process.

In addition, the method for eliminating the interstitial-type defect B-swirl in the silicon wafer according to the above embodiment can also have the following additional technical features:
In some embodiments of the present disclosure, in the step (1), the first preset temperature is 700-800 °C, and the holding time is 5-25 seconds.

In some embodiments of the present disclosure, in the step (2), the second preset temperature is 1150°C-1200 °C, and the holding time is 10-30 seconds.

In some embodiments of the present disclosure, in the step (2), a flow rate of nitrogen is 50-100 SLM.

In some embodiments of the present disclosure, in the step (3), the third preset temperature is 1000-1100 °C.

In some embodiments of the present disclosure, in the step (3), a rate of temperature decrease is 50-100 °C/s.

In some embodiments of the present disclosure, a vacancy concentration of the near surface of silicon wafer obtained in the step (3) is 10⁴-10⁸ cm⁻³.

In some embodiments of the present disclosure, the vacancy concentration of the near surface of the silicon wafer obtained in the step (3) is A₁ × 10⁴ cm⁻³, wherein 1≤A_{1<}10, and A₁ ∈ a real number; a rate of temperature decrease in step (3) is 50-65 °C/s; the second preset temperature in the step (2) is 1150 °C-1160 °C; and the flow rate of the nitrogen in the step (2) is 50-100 SLM.

Or, the vacancy concentration of the near surface of silicon wafer obtained in the step (3) is A₂ × 10⁵ cm⁻³, wherein 1≤A_{2<}10, and A₂ ∈ a real number; a rate of temperature decrease in the step (3) is 65-75 °C/s; the second preset temperature in the step (2) is 1160 °C-1190 °C; and the flow rate of the nitrogen in the step (2) is 50-100 SLM.

Or, the vacancy concentration of the near surface of silicon wafer obtained in the step (3) is A₃ × 10⁶ cm⁻³, wherein 1≤A_{3<}10, and A₃ ∈ a real number; a rate of temperature decrease in the step (3) is 75-85 °C/s; the second preset temperature in the step (2) is 1160 °C-1190 °C; and the flow rate of the nitrogen in the step (2) is 50-100 SLM.

Or, the vacancy concentration of the near surface of silicon wafer obtained in the step (3) is A₄ × 10⁷ cm⁻³, wherein 1≤A_{4<}10, and A₄ ∈ a real number; a rate of temperature decrease in the step (3) is 85-95 °C/s; the second preset temperature in the step (2) is 1160 °C-1190 °C; and the flow rate of the nitrogen in the step (2) is 50-100 SLM.

Or, the vacancy concentration of the near surface of silicon wafer obtained in the step (3) is A₅ × 10⁸ cm⁻³, wherein 1≤A_{5<}10, and A₅ ∈ a real number; a rate of temperature decrease in the step (3) is 95-100 °C/s; the second preset temperature in the step (2) is 1190 °C-1200 °C; and the flow rate of the nitrogen in the step (2) is 50-100 SLM.

In some embodiments of the present disclosure, in the step (4), the fourth preset temperature is 1250-1300 °C, and the holding time is 10-30 seconds.

In some embodiments of the present disclosure, in the step (1) and the step (4), the inert atmosphere is independently an argon atmosphere.

According to another aspect of the present disclosure, the present disclosure provides a silicon wafer. According to an embodiment of the present disclosure, the silicon wafer is obtained by the method described in the above embodiments. Thus, the quality of the silicon wafer is improved, not affecting the effect of an IC manufacturing process.

According to a third aspect of the present disclosure, the present disclosure provides an electronic device. According to an embodiment of the present disclosure, the electronic device has the silicon wafer processed by the method described in the above embodiment or the silicon wafer described in the above embodiment. Thus, the electronic device has all the advantages of the above silicon wafer, which will not be elaborated here.

The additional aspects and advantages of the present disclosure will be partially provided in the following descriptions, some of which will become apparent from the following descriptions, or learned through the practice of the present disclosure.

### Brief Description of the Drawings

The above and/or additional aspects and advantages of the present disclosure will become apparent and readily understood from the following descriptions of the embodiments in conjunction with the following drawings, in which:
Fig. 1 is a flowchart of a method for eliminating an interstitial-type defect B-swirl in a silicon wafer according to an embodiment of the present disclosure;
Fig. 2 is a B-swirl diagram of a copper decoration method for the silicon wafer that is not annealed in Embodiment 1;
Fig. 3 is a B-swirl diagram of a copper decoration method for the silicon wafer that is annealed in Embodiment 1;
Fig. 4 is a B-swirl diagram of a copper decoration method for the silicon wafer that is not annealed in Embodiment 2;
Fig. 5 is a B-swirl diagram of a copper decoration method for the silicon wafer that is annealed in Embodiment 2;
Fig. 6 is a B-swirl diagram of a copper decoration method for the silicon wafer that is not annealed in comparative embodiment 1; and
Fig. 7 is a B-swirl diagram of a copper decoration method for the silicon wafer that is annealed in comparative embodiment 1.

### Detailed Description of the Embodiments

The embodiments of the present disclosure are described in detail below, and examples of the embodiments are shown in drawings, where the same or similar elements or the elements having same or similar functions are denoted by the same or similar reference numerals throughout the description. The embodiments described below with reference to the drawings are exemplary and used only for explaining the present disclosure, and should not be construed as a limitation on the present disclosure.

According to Voronkov's V/G theory, in a process of producing monocrystalline silicon by CZ method, under a certain thermal field, a pulling speed V will cause micro-defects in a single crystal. When the pulling speed V is too high, vacancy defects will be formed in the monocrystalline silicon. When the pulling speed V is too low, interstitial-type defects will be formed in the monocrystalline silicon. B-swirl is a defect ring formed by aggregation of silicon atoms at an interstitial position where the silicon atoms are located.

A perfect crystal or a defect-free crystal does not refer to an absolutely perfect crystal or a crystal without any defects, but allows for one or more crystal defects in an insignificant amount that is not sufficient to make significant changes in the electrical or mechanical properties of the crystal or an obtained wafer, and lead to the deterioration of the performance of electronic devices using the crystal or the wafer.

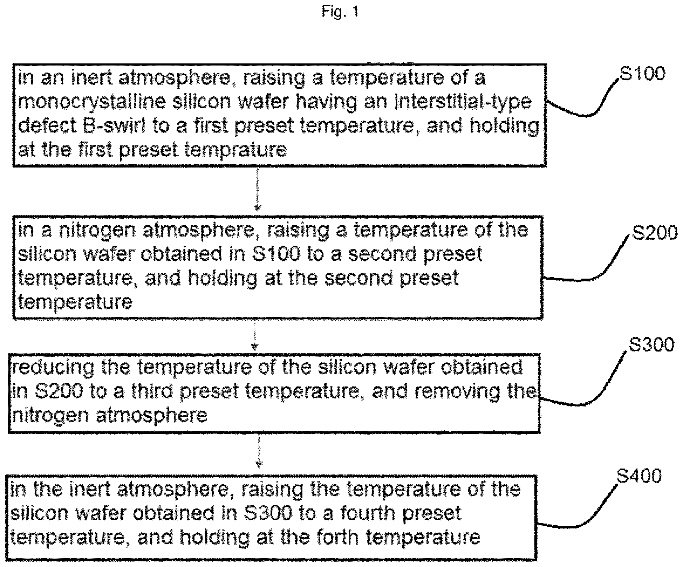

According to one aspect of the present disclosure, the present disclosure provides a method for eliminating an interstitial-type defect B-swirl. According to an embodiment of the present disclosure, referring to Fig. 1, the method includes:
S100: In an inert atmosphere, a temperature of a monocrystalline silicon wafer, which has an interstitial-type defect B-swirl, is increased to a first preset temperature, and the temperature is maintained.

In this step, in the inert atmosphere, the temperature of the monocrystalline silicon wafer, which has the interstitial-type defect B-swirl, is raised to the first preset temperature, and the temperature is maintained, so as to eliminate a thermal donor inside the silicon wafer, thus achieving the purpose of reducing consumption of vacancies by interstitial oxygen, the purpose of reducing the consumption of the interstitial oxygen for the vacancy is achieved. Specifically, when the silicon wafer is heated to the first preset temperature, the saturation of the interstitial oxygen in the silicon wafer is increased, and the precipitated interstitial oxygen is dissolved back into the silicon wafer, thereby achieving the purpose of eliminating the interstitial oxygen at interstitial positions.

In this embodiment of the present disclosure, B-swirl is a defect caused by silicon atoms at the interstitial positions in the silicon wafer. Specifically, B-swirl is a defect ring formed by aggregation of the silicon atoms at the interstitial positions. B-swirl is a small-sized three-dimensional interstitial aggregate with a concentration of about 10⁴-10⁸ cm⁻³.

According to a specific embodiment of the present disclosure, the first preset temperature is 700-800 °C, and the holding time is 5-25 seconds. Therefore, the first preset temperature and the holding time are limited within the above range to further facilitate the elimination of the interstitial oxygen at the interstitial position, thereby achieving the purpose of reducing the consumption of vacancies by the interstitial oxygen.

In the embodiment of the present disclosure, the type of inert gas used in this step is not particularly limited. Those skilled in the art can freely choose the type according to actual needs, such as argon or the like.

S200: In a nitrogen atmosphere, a temperature of the silicon wafer, which is obtained in step S100, is raised to a second preset temperature, and the temperature is maintained.

In this step, in the nitrogen atmosphere, the temperature of the silicon wafer, which is obtained in step S100, is increased to the second preset temperature, and the temperature is maintained. As the heat treatment performed under the protection of N₂ causes the surface of the silicon wafer to be nitrified, and a large number of vacancies are injected to form a high-concentration vacancy region on a near surface of the silicon wafer, with the purpose of providing sufficient vacancies for annihilation with the interstitial silicon atoms in the subsequent step. The near surface refers to a range of 0-100 µm from the surface.

According to another specific embodiment of the present disclosure, the second preset temperature is 1150 °C-1200 °C, and the holding time is 10-30 seconds. Therefore, the second preset temperature and holding time are limited to the above-mentioned range, and it is beneficial to form a reasonable concentration of vacancy regions on the near surface of the silicon wafer. The inventor found that if the second preset temperature is too high or the holding time is too long, the vacancy concentration provided will be too high, resulting in a new vacancy-type defect. If the second preset temperature is too low or the holding time is too short, the vacancy concentration provided will be too low, and the vacancies cannot be completely combined with the interstitial silicon atoms. As a result, excessive interstitial silicon atoms remain in the silicon wafer.

According to still another specific embodiment of the present disclosure, the flow rate of the nitrogen is 50-100 SLM. Therefore, the flow rate of the nitrogen is limited within the above-mentioned range, and further conducive to forming a reasonable concentration of vacancy regions on the near surface of the silicon wafer. It should be noted that SLM is the unit of flow rate, i. e L/min.

S300: The temperature of the silicon wafer, which is obtained in step S200, is decreased to a third preset temperature, and the nitrogen atmosphere is removed.

In this step, the temperature of the silicon wafer, which is obtained in the step S200, is decreased to the third preset temperature, and the nitrogen atmosphere is removed, so as to remain vacancies of the vacancy region on the near surface of the silicon wafer and prevent the outer diffusion of vacancies during the continuous high-temperature process from causing to decrease the concentration of vacancies on the near surface. It should be noted that the higher the temperature, the faster the outward diffusions of vacancies, and the fewer vacancies remain on the near surface of silicon wafer.

According to yet another specific embodiment of the present disclosure, the third preset temperature is 1000-1100 °C. Therefore, the third preset temperature is limited within the above-mentioned range, and the temperature is further rapidly and slightly lowed so that the vacancies remain on the near surface of the silicon wafer, which further prevents the outward diffusion of vacancies during the continuous high-temperature process from reducing the concentration of vacancies of the near surface. The inventor found that if the third preset temperature is too low, there may be a risk of slippage or fragmentation of the silicon wafer; and if the third preset temperature is too high, it will cause outward diffusion of vacancies and reduce the vacancy concentration of the near surface.

It should be noted that the holding time in this step is not limited. As long as the temperature of the silicon wafer is decreased to the third preset temperature, the process of remaining the vacancies on the near surface of the silicon wafer is completed.

According to still yet another specific embodiment of the present disclosure, a rate of temperature decrease is 50-100 °C/s. Therefore, the temperature decrease rate is limited to the above-mentioned range to further achieve rapid slight cooling to remain the vacancies on the near surface of the silicon wafer, which further prevents the decrease in the vacancy concentration of the near surface caused by the outward diffusion of the vacancies during the continuous high-temperature process.

According to still yet another specific embodiment of the present disclosure, the vacancy concentration of the near surface of silicon wafer obtained in step S300 is 10⁴-10⁸ cm⁻³. The vacancy concentration here refers to a concentration of vacancies in the overall silicon wafer, therefore, it is further beneficial to keep the vacancy concentration in the vacancy region consistent with a B-swirl defect concentration, without introducing excess defects. The vacancies are sufficient to recombine with the interstitial silicon atoms.

As mentioned earlier, the concentration of the interstitial-type defect B-swirl in the silicon wafer described above is about 10⁴-10⁸ cm⁻³, which can be directly detected by LSTD (laser scattering tomography defect). In order to eliminate the B-swirl defect and avoid excess defects, it is necessary to control the vacancy concentration of the near surface of the silicon wafer described above to be equivalent to the concentration of the interstitial-type defect B-swirl in the silicon wafer. It should be noted that the vacancy concentration of the near surface of the silicon wafer obtained in step S300 is related to the temperature decrease rate in step S300, the second preset temperature in step S200, and the flow rate of the nitrogen in step S200. Specifically:
When a rate of temperature decrease in step S300 is 50-65 °C/s, the second preset temperature in step S200 is 1150°C-1160 °C, and the flow rate of the nitrogen in step S200 is 50-100 SLM, the vacancy concentration of the near surface of the silicon wafer obtained in step S300 is A₁×10⁴ cm⁻³, where 1≤A_{1<}10, and A1 ∈ a real number.

When a rate of temperature decrease in step S300 is 65-75 °C/s, the second preset temperature in step S200 is 1160 °C-1190 °C, and the flow rate of the nitrogen in step S200 is 50-100 SLM, the vacancy concentration of the near surface of the silicon wafer obtained in step S300 is A₂×10⁵ cm⁻³, where 1≤A₂<10, and A₂ ∈ a real number.

When a rate of temperature decrease in step S300 is 75-85 °C/s, the second preset temperature in step S200 is 1160 °C-1190 °C, and the flow rate of the nitrogen in step S200 is 50-100 SLM, the vacancy concentration of the near surface of the silicon wafer obtained in step S300 is A₃×10⁶ cm⁻³, where 1≤A_{3<}10, and A₃ ∈ a real number.

When a rate of temperature decrease in step S300 is 85-95 °C/s, the second preset temperature in step S200 is 1160 °C-1190 °C, and the flow rate of the nitrogen in step S200 is 50-100 SLM, the vacancy concentration of the near surface of the silicon wafer obtained in step S300 is A₄×10⁷ cm⁻³, where 1≤A_{4<}10, and A₄ ∈ a real number.

When a rate of temperature decrease in step S300 is 95-100 °C/s, the second preset temperature in step S200 is 1190 °C-1200 °C, and the flow rate of the nitrogen in step S200 is 50-100 SLM, the vacancy concentration of the near surface of the silicon wafer obtained in step S300 is A₅×10⁸ cm⁻³, where 1≤A_{5<}10, and A₅ E a real number.

S400: In the inert atmosphere, the temperature of the silicon wafer, which is obtained in step S300, is increased to a fourth preset temperature, and the temperature is maintained.

In this step, in the inert atmosphere, the temperature of the silicon wafer obtained in step S300, is increased to the fourth preset temperature, and the temperature is maintained, so that interstitial silicon atoms inside the silicon wafer can diffuse outwards and recombine and annihilate with the vacancies on the near surface. It should be noted that the number of the interstitial silicon atoms diffused outwards and the vacancies formed on the near surface to be equal, at least in the same order of magnitude. If there are too many vacancies, the temperature decrease rate in S300 will be reduced, thereby reducing the vacancy concentration formed on the near surface. If there are too many interstitial silicon atoms diffused outwards, the temperature decrease rate in S300 is accelerated or the second preset temperature is increased, thereby increasing the vacancy concentration formed on the near surface.

According to still another specific embodiment of the present disclosure, the fourth preset temperature is 1250 °C-1300 °C and the holding time is 10-30 seconds. Therefore, the fourth preset temperature and holding time are limited to the above range, which further ensure that the interstitial silicon atoms inside the silicon wafer are diffused outward from the interstitial space and recombined and annihilated with the vacancies formed on the near surface. The inventor found that if the temperature is too high or the holding time is too long, there is a risk of slippage or fragmentation of the silicon wafer. If the temperature is too low or the holding time is too short, it will be impossible to effectively complete the outward diffusion of the interstitial silicon atoms and the combination with the high-concentration vacancies of the near surface for annihilation.

In the embodiment of the present disclosure, the type of the inert gas used in this step is not particularly limited, and those skilled in the art can freely choose the type according to actual needs, such as argon and the like.

According to the method for eliminating the interstitial-type defect B-swirl in the silicon wafer according to the embodiment of the present disclosure, the temperature of the silicon wafer with the interstitial-type defect B-swirl is first increased to the first preset temperature, and the temperature is maintained, so as to eliminate the thermal donor inside the silicon wafer; in the nitrogen atmosphere, the temperature of the silicon wafer is then increased to the second preset temperature, and the temperature is maintained, so as to form the vacancy region on the near surface of the silicon wafer; the temperature of the silicon wafer is decreased to the third preset temperature, and the nitrogen atmosphere is removed, so as to remain the vacancies of the vacancy region on the near surface of the silicon wafer and prevent the vacancies from continuing to diffuse outwards during the continuous high-temperature process, resulting in a decrease in the concentration of vacancies near the surface; and finally, the temperature of the silicon wafer is increased to the fourth preset temperature, and the temperature is maintained, so as to enable the interstitial silicon atoms inside the silicon wafer to diffuse outwards and recombine with the vacancies on the near surface to eliminate. Thus, the interstitial-type defect B-swirl in the silicon wafer is eliminated through high-temperature rapid thermal process, and it is transformed into a perfect wafer without new defects, which improves the quality of the silicon wafer, without affecting the effect of an IC manufacturing process.

According to another aspect of the present disclosure, the present disclosure provides a silicon wafer. According to an embodiment of the present disclosure, the silicon wafer is obtained by using the method described in the above embodiment. Thus, the quality of the silicon wafer is improved, without affecting the effect of an IC manufacturing process.

According to a third aspect of the present disclosure, the present disclosure provides an electronic device. According to an embodiment of the present disclosure, the electronic device has the silicon wafer processed by the method of the above embodiment or silicon wafer of the above embodiment. Thus, the electronic device has all the advantages of the above silicon wafer, and will not be elaborated here.

The following is a detailed description of the embodiments of the present disclosure. It should be noted that the embodiments described below are exemplary, are only intended to explain the present disclosure, and cannot be understood as limiting the present disclosure. In addition, if not explicitly stated, all reagents used in the following embodiments are commercially available or can be synthesized according to the method described herein or the existing method. For reaction conditions not listed, these reagents are also readily available to those skilled in the art.

### Embodiment 1

Two consecutive silicon wafers with interstitial-type defects B-Swirl produced from the same ingot are tested by LSTD, obtaining that the concentrations of the interstitial-type defects B-swirl in the silicon wafers are 10⁴ cm⁻³. One silicon wafer does not undergo high-temperature rapid annealing, and the other silicon wafer undergoes high-temperature rapid annealing. The high-temperature rapid annealing includes the following steps:
Put the silicon wafer with the interstitial-type defect B-swirl into a rapid annealing furnace with an argon atmosphere for annealing treatment; rapidly raise the temperature to 700 °C; and hold the temperature for 10 seconds.

Introduce N₂ with a flow rate of 50 SLM; continue to heat up to 1150 °C; and hold the temperature for 15 seconds.

Cool down to 1050 °C at a rate of 50 °C/s, and stop supplying N₂.

Continue to raise the temperature to 1250 °C in an argon atmosphere, and hold the temperature for 10 seconds, cool down to the room temperature at the rate of 50 °C/s, thereby eliminating B-swirl in the silicon wafer and obtaining a perfect crystal silicon wafer.

The above-mentioned silicon wafers without annealing treatment and silicon wafers with annealing treatment are tested by a copper decoration method respectively. The copper decoration method includes testing steps: (1) Determine the thicknesses of the silicon wafer samples. (2) Clean the samples, first with tap water and then clean the surface of the samples with a surfactant; and surface particles were removed with KOH. (3) Chemical polishing, the surfaces of the samples are polished and cleaned by MAE-A liquid (a mixed solution of nitric acid, acetic acid, and hydrofluoric acid). (4) Copper nitrate coating. (5)H heat treatment at 900°C for 4 hours. (6) Chemical polishing, the surfaces of the samples are polished and cleaned by using MAE-B (a mixed solution of hydrofluoric acid, potassium dichromate, and acetic acid). (7) Etching, Secco etching is performed for 45 minutes for development. (8) Photographing.

The basic principle of the copper decoration method is that copper precipitates will generate compressive stresses in a surrounding region of micro-defects. The compressive stresses will be relieved by release of silicon atoms, which will form new dislocations around the copper. The copper precipitates are then formed at these dislocations. As many copper precipitates and dislocations are all formed around the micro-defects, forming a larger region, it is easy to observe under a microscope.

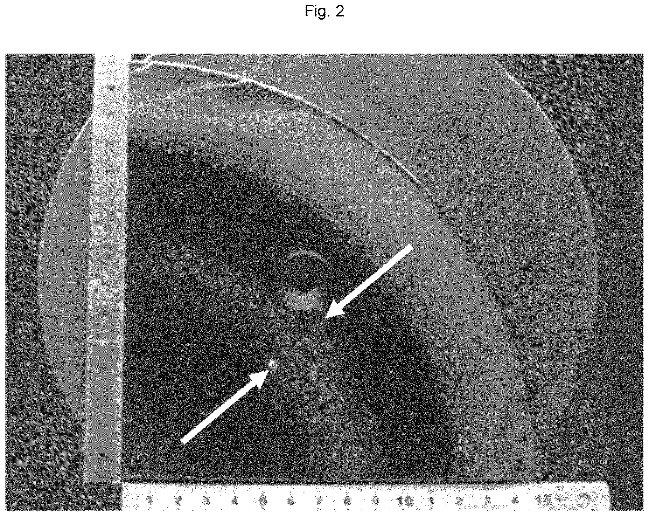

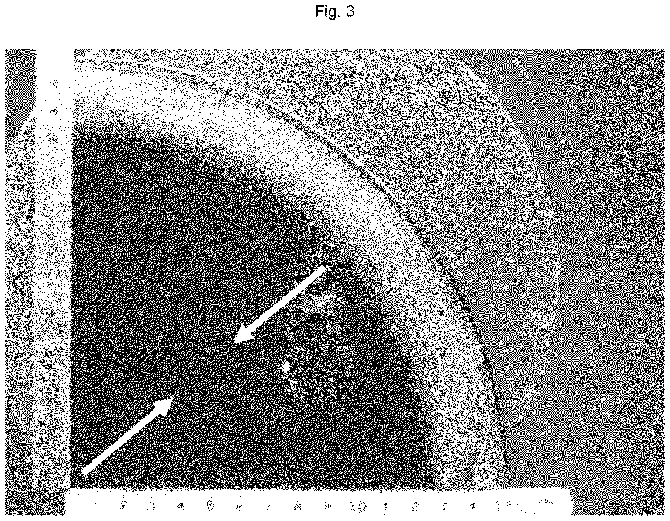

Test results are shown in Fig. 2 and Fig. 3. Fig. 2 is the B-swirl diagram of the silicon wafer that has been not annealed, and Fig. 3 is the B-swirl diagram of the silicon wafer that has been annealed. The region indicated by the arrow in Fig. 2 is the B-swirl region, and there are white spots in this region, which means that there are B-swirl defects in the wafer. There are no white spots in the region indicated by the arrow in Fig. 3, which means that no copper precipitate is formed in this region, namely, this region is a perfect region without defects. It can be seen that after the annealing treatment, the defects in the wafer are eliminated.

### Embodiment 2

Two consecutive silicon wafers with interstitial-type defects B-Swirl produced from the same ingot are tested by LSTD, the order of magnitude of the interstitial-type defects B-swirl concentrations in the silicon wafer is 10⁵ cm⁻³. One silicon wafer does not undergo high-temperature rapid annealing and the other silicon wafer undergoes high-temperature rapid annealing. High-temperature rapid annealing includes the following steps:
Put the silicon wafer with interstitial-type defect B-swirl into the annealing furnace with argon atmosphere for annealing treatment; rapidly raise the temperature to 750 °C; and hold the temperature for 12 seconds.

Introduce N₂ with a flow rate of 75 SLM; continue to heat up to 1165 °C; and hold the temperature for 20 seconds.

Cool down to 1090 °C at a rate of 65 °C/s, and stop supplying N₂.

Continue to raise the temperature to 1265 °C in an argon atmosphere, hold the temperature for 25 seconds, and cool down to room temperature at the rate of 60 °C/s, thereby eliminating B-swirl in the silicon wafer and obtaining a perfect crystal silicon wafer.

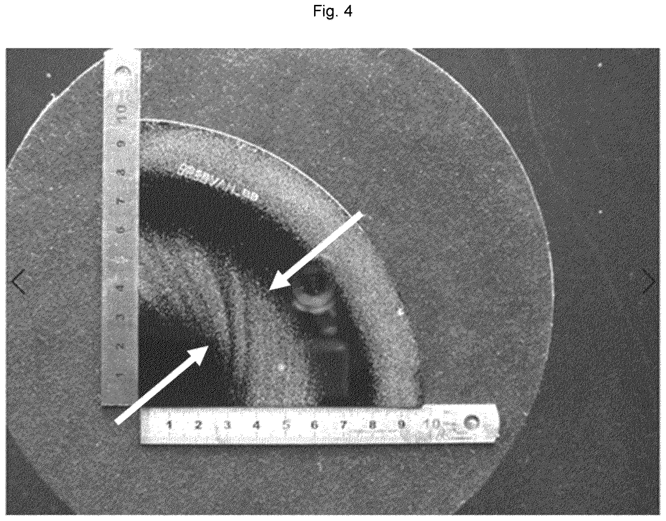

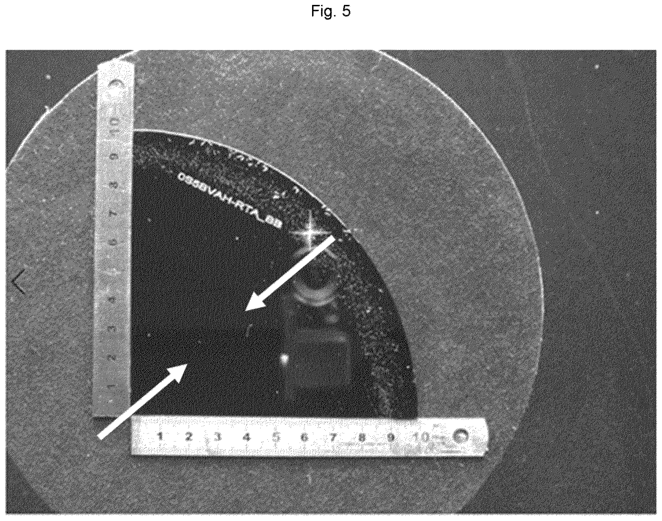

The above-mentioned silicon wafers without annealing treatment and silicon wafers with annealing treatment are tested by the copper decoration method. Test results are shown in Fig. 4 and Fig. 5, wherein Fig. 4 is a B-swirl diagram of the silicon wafer without annealing treatment, and Fig. 5 is a B-swirl diagram of the silicon wafer with annealing treatment. The region indicated by the arrow in Fig. 4 is the B-swirl region, and there are white spots in this region, which means that there are B-swirl defects in the wafer. The region indicated by the arrow in Fig. 5 is the B-swirl region, and there are no white spots in the region, which means that no copper precipitate is formed in this region, namely, this region is a perfect region without defects. It can be seen that after the annealing treatment, the defects in the wafer are eliminated.

### Embodiment 3

Two consecutive silicon wafers with interstitial-type defects B-Swirl produced from the same ingot are tested by LSTD, the order of magnitude of the interstitial-type defects B-swirl concentrations in the silicon wafers is 10⁶ cm⁻³. One silicon wafer does not undergo high-temperature rapid annealing and the other silicon wafer undergoes high-temperature rapid annealing. High-temperature rapid annealing includes the following steps:
Put the silicon wafer with interstitial-type defect B-swirl into the annealing furnace with argon atmosphere for annealing treatment; rapidly raise the temperature to 760 °C; and hold the temperature for 15 seconds.

Introduce N₂ with a flow rate of 60 SLM; continue to heat up to 1175 °C; and hold the temperature for 20 seconds.

Cool down to 1080 °C at a rate of 80 °C/s, and stop supplying N₂.

Continue to raise the temperature to 1260 °C in an argon atmosphere, hold the temperature for 13 seconds, cool down to room temperature at the rate of 80 °C/s, and thereby eliminating B-swirl in the silicon wafer and obtaining a perfect crystal silicon wafer.

The above-mentioned silicon wafers without annealing treatment and silicon wafers with annealing treatment are tested separately by the copper decoration method. Test results are as follows: There are white spots in the B-swirl region in the B-swirl diagram of the silicon wafer without annealing treatment, indicating that the wafer has the defect B-swirl. There are no white spot in the B-swirl region in the B-swirl diagram of the silicon wafer with annealing treatment, which means that no copper precipitate is formed here, that is, it is a perfect region without defects. It can be seen that after the annealing treatment, the defects inside the wafer are eliminated. Test pictures of this embodiment are similar to those in Embodiment 1 and Embodiment 2, and will not be repeated here.

### Embodiment 4

Two consecutive silicon wafers with interstitial-type defects B-Swirl produced from the same ingot are tested by LSTD, the order of magnitude of the interstitial-type defects B-swirl concentrations in the silicon wafers is 10⁷ cm⁻³. One silicon wafer does not undergo high-temperature rapid annealing and the other silicon wafer undergoes high-temperature rapid annealing. High-temperature rapid annealing included the following steps:
Put the silicon wafer with the interstitial-type defect B-swirl into an annealing furnace with argon atmosphere for annealing treatment; rapidly raise the temperature to 755 °C; and hold the temperature for 20 seconds.

Introduce N₂ with a flow rate of 75 SLM; continue to heat up to 1180 °C; and hold the temperature for 15 seconds.

Cool down to 1070 °C at a rate of 85 °C/s, and stop supplying N₂.

Continue to raise the temperature to 1290 °C in an argon atmosphere, hold the temperature for 15 seconds, and cool down to room temperature at the rate of 85 °C/s, thereby eliminating B-swirl in the silicon wafer and obtaining a perfect crystal silicon wafer.

The above-mentioned silicon wafers without annealing treatment and silicon wafers with annealing treatment are tested separately by the copper decoration method. Test results are as follows: there are white spots in the B-swirl region in the B-swirl diagram of the silicon wafer without annealing treatment, indicating that the wafer has B-swirl defects. There is no white spot in the B-swirl region in the B-swirl diagram of the silicon wafer with annealing treatment, which means that no copper precipitates is formed here, that is, it is a perfect region without defects. It can be seen that after the annealing treatment, the defects in the wafer are eliminated. Test pictures of this embodiment are similar to those in Embodiment 1 and Embodiment 2, and will not be repeated here.

### Embodiment 5

Two consecutive silicon wafers with interstitial-type defects B-Swirl produced from the same ingot are tested by LSTD, the order of magnitude of interstitial-type defects B-swirl concentrations in the silicon wafers are 10⁸ cm⁻³. One silicon wafer does not undergo high-temperature rapid annealing and the other silicon wafer undergoes high-temperature rapid annealing. High-temperature rapid annealing includes the following steps:
Put silicon wafer with the interstitial-type defect B-swirl into an annealing furnace with argon atmosphere for annealing treatment, rapidly raise the temperature to 750 °C; and hold the temperature for 15 seconds.

Introduce N₂ with a flow rate of 80 SLM, continue to heat up to 1200 °C; and hold the temperature for 15 seconds.

Cool down to 1090 °C at a rate of 95 °C/s, and stop supplying N₂.

Continue to raise the temperature to 1300 °C in an argon atmosphere, hold the temperature for 20 seconds, and cool down to room temperature at the rate of 100 °C/s, thereby eliminating B-swirl in the silicon wafer and obtaining a perfect crystal silicon wafer.

The above-mentioned silicon wafers without annealing treatment and silicon wafers with annealing treatment are tested separately by the copper decoration method. Test results are as follows: There are white spots in the B-swirl region in the B-swirl diagram of the silicon wafer without annealing treatment, indicating that the wafer has B-swirl defects. There is no white spot in the B-swirl region in the B-swirl diagram of the silicon wafer with annealing treatment, which means that no copper precipitate is formed here, that is, it is a perfect region without defects. It can be seen that after the annealing treatment, the defects in the wafer are eliminated. Test pictures of this embodiment are similar to those in Embodiment 1 and Embodiment 2, and will not be repeated here.

### Comparative embodiment 1

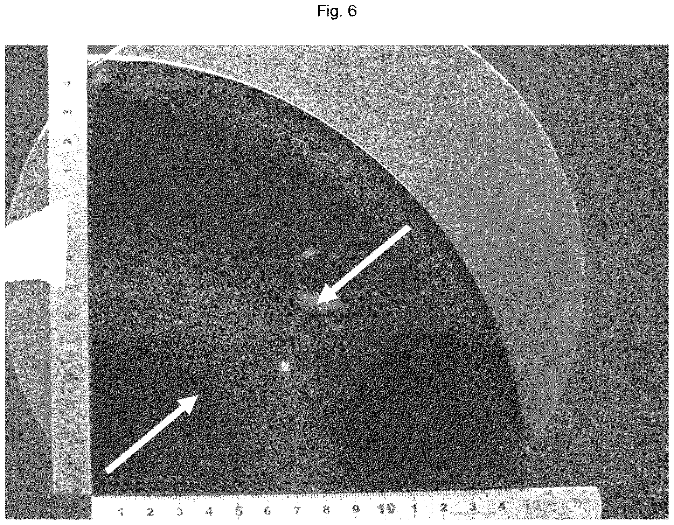

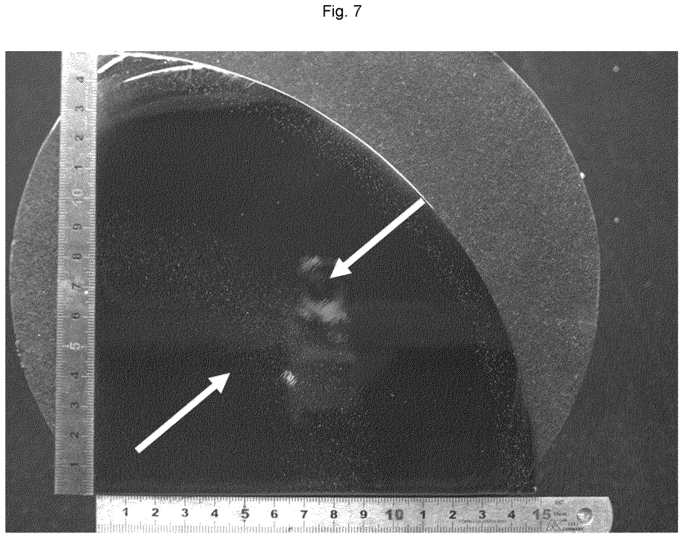

In the comparative embodiment, the fourth preset temperature is 1230 °C, and other contents are the same as those in Embodiment 1. The silicon wafer without annealing treatment and the silicon wafer with annealing treatment are tested separately by the copper decoration method. Test results are shown in Fig. 6 and Fig. 7. Fig. 6 is a B-swirl diagram of the silicon wafer without annealing treatment, and Fig. 7 is a B-swirl diagram of the silicon wafer with annealing treatment. The region indicated by the arrow in Fig. 6 is a B-swirl region, there are white spots in this region, which means that the wafer has B-swirl defects in the wafer. The region indicated by the arrow in Fig. 7 is a B-swirl region, there are white spots, which means that the wafer has B-swirl defects in the wafer. It is possible that the fourth preset temperature is too low, which prevents interstitial silicon atoms from completing timely out-diffusion, recombination and annihilation with high-concentration vacancies near surface.

In the description of this specification, the description referring to the terms "one embodiment", "some embodiments", "an embodiment", "specific embodiments", "some embodiments", or the like means that specific features, structures, materials or characteristics described in connection with the embodiments or embodiments are included in at least one embodiment or embodiment of the present disclosure. In this specification, the schematic representations of the above terms are not necessarily intended to refer to the same embodiment or embodiment. Furthermore, the specific features, structures, materials or characteristics described may be combined in any suitable manner in any one or more embodiments or embodiments. In addition, those skilled in the art may combine the different embodiments or embodiments described in this specification, as well as the features of different embodiments or embodiments, without mutual contradictions.

## Claims

1. A method for eliminating an interstitial-type defect B-swirl, comprising:
(1) in an inert atmosphere, raising a temperature of a monocrystalline silicon wafer having an interstitial-type defect B-swirl to a first preset temperature, and holding at the first preset temperature, so as to eliminate a thermal donor inside the silicon wafer;
(2) in a nitrogen atmosphere, raising a temperature of the silicon wafer obtained in step (1) to a second preset temperature, and holding at the second preset temperature, so as to form a vacancy region on a near surface of silicon wafer;
(3) reducing the temperature of the silicon wafer obtained in step (2) to a third preset temperature, and removing the nitrogen atmosphere, so as to remain vacancies in the vacancy region on the near surface of silicon wafer; and
(4) in the inert atmosphere, raising the temperature of the silicon wafer obtained in step (3) to a fourth preset temperature, and holding at the forth temperature, so as to enable the self-interstitial silicon atoms in the interior of the silicon wafer to diffuse outside and recombine with the vacancies on the near surface for annihilation.

2. The method according to claim 1, wherein in step (1), the first preset temperature is 700-800 °C, and the holding time is 5-25 seconds.

3. The method according to claim 1 or 2, wherein in step (2), the second preset temperature is 1150 °C-1200 °C, and the holding time is 10-30 seconds.

4. The method according to any one of claims 1 to 3, wherein in step (2), a flow rate of nitrogen is 50-100 SLM.

5. The method according to any one of claims 1 to 4, wherein in step (2), the near surface is a region that is 0-100 µm away from a surface of silicon wafer.

6. The method according to any one of claims 1 to 5, wherein in step (3), the third preset temperature is 1000-1100 °C.

7. The method according to any one of claims 1 to 6, wherein in step (3), a rate of temperature decrease is 50-100 °C/s.

8. The method according to any one of claims 1 to 7, wherein a vacancy concentration of the near surface of silicon wafer obtained in step (3) is 10⁴-10⁸ cm⁻³.

9. The method according to any one of claims 1 to 8, wherein the vacancy concentration of the near surface of silicon wafer obtained in step (3) is A₁ × 10⁴ cm⁻³, wherein 1≤A_{1<}10, and A₁ ∈ a real number; a rate of temperature decrease in step (3) is 50-65 °C/s; the second preset temperature in step (2) is 1150 °C-1160 °C; and the flow rate of the nitrogen in step (2) is 50-100 SLM;
or, the vacancy concentration of the near surface of silicon wafer obtained in step (3) is A₂ × 10⁵ cm⁻³, wherein 1≤A_{2<}10, and A₂ ∈ a real number; a rate of temperature decrease in step (3) is 65-75 °C/s; the second preset temperature in step (2) is 1160 °C-1190 °C; and the flow rate of the nitrogen in step (2) is 50-100 SLM;
or, the vacancy concentration of the near surface of silicon wafer obtained in step (3) is A₃ × 10⁶ cm⁻³, wherein 1≤A_{3<}10, and A₃ ∈ a real number; a rate of temperature decrease in step (3) is 75-85 °C/s; the second preset temperature in step (2) is 1160 °C-1190 °C; and the flow rate of the nitrogen in step (2) is 50-100 SLM;
or, the vacancy concentration of the near surface of silicon wafer obtained in step (3) is A₄ × 10⁷ cm⁻³, wherein 1≤A_{4<}10, and A₄ ∈ a real number; a rate of temperature decrease in step (3) is 85-95 °C/s; the second preset temperature in step (2) is 1160 °C-1190 °C; and the flow rate of the nitrogen in step (2) is 50-100 SLM;
or, the vacancy concentration of the near surface of silicon wafer obtained in step (3) is A₅ × 10⁸ cm⁻³, wherein 1≤A_{5<}10, and A₅ ∈ a real number; a rate of temperature decrease in step (3) is 95-100 °C/s; the second preset temperature in step (2) is 1190 °C-1200 °C; and the flow rate of the nitrogen in step (2) is 50-100 SLM.

10. The method according to any one of claims 1 to 9, wherein in step (4), the fourth preset temperature is 1250-1300 °C, and the holding time is 10-30 seconds.

11. The method according to any one of claims 1 to 10, wherein in step (1) and step (4), the inert atmosphere is independently an argon atmosphere.

12. A silicon wafer, wherein the silicon wafer is obtained by the method according to any one of claims 1 to 11.

13. An electronic device, wherein the electronic device has the silicon wafer processed by the method according to any one of claims 1 to 11 or the silicon wafer according to claim 12.
